# DEMANDE DE BREVET EUROPEEN

(11) **EP 2 348 528 A1**
(43) Date de publication de la demande: **27.07.2011**
(21) Numéro de dépôt: 11151892.4
(22) Date de dépôt: 24.01.2011
(51) Int. Cl.: H01L 27/02

(54) **Structure de protection d'un circuit intégré contre des décharges électrostatiques**

(30) Priorité: 26.01.2010 FR 1050493
(71) Demandeur: STMicroelectronics (Rousset) SAS, 13790 Rousset (FR)
(72) Inventeur: Tailliet, François, 13710, FUVEAU (FR)
(74) Mandataire: de Beaumont, Michel

(57) **Abrégé**

L'invention concerne un circuit intégré protégé contre des décharges électrostatiques, ce circuit intégré comprenant des plots d'entrée-sortie (I01, 102, I03) et des premier (40, V_{DD}) et second (GND) rails d'alimentation, et : un thyristor (43) connecté en direct entre chaque plot d'entrée-sortie et le second rail, chaque thyristor comportant, entre sa gâchette d'anode et son anode une résistance ; entre chaque thyristor et le premier rail, une diode (45) dont l'anode est reliée à la gâchette d'anode du thyristor et dont la cathode est reliée au premier rail par l'intermédiaire d'une résistance (Rd1, Rd2, Rd3) d'ajustement du déclenchement ; et un dispositif de déclenchement (47) adapté à laisser circuler un courant entre les premier et second rails lorsqu'une surtension positive survient entre ces rails.

## Description

### Domaine de l'invention

La présente invention concerne la protection des circuits intégrés contre des décharges électrostatiques.

### Exposé de l'art antérieur

Un circuit intégré comprend des plots métalliques destinés à assurer des connexions vers l'extérieur. Certains des plots sont adaptés à recevoir des potentiels d'alimentation. Les autres plots sont adaptés à recevoir et/ou à fournir des signaux d'entrée-sortie. Des rails d'alimentation, reliés aux plots d'alimentation, sont généralement prévus tout autour du circuit pour alimenter ses différents composants. Généralement, une couche isolante recouvre le circuit, ne laissant accessible que les plots métalliques.

Un tel circuit reçoit et/ou fournit généralement des signaux à faible niveau de tension (par exemple 1 à 5 V) et à faible intensité de courant (par exemple 1 **µ**A à 10 mA), et est susceptible d'être endommagé lorsque des surtensions ou des surintensités surviennent entre des plots du circuit.

On prévoit donc d'associer à chaque plot une structure de protection. La structure de protection doit pouvoir évacuer rapidement des courants importants, susceptibles d'apparaître lorsqu'une décharge électrostatique survient entre deux plots du circuit.

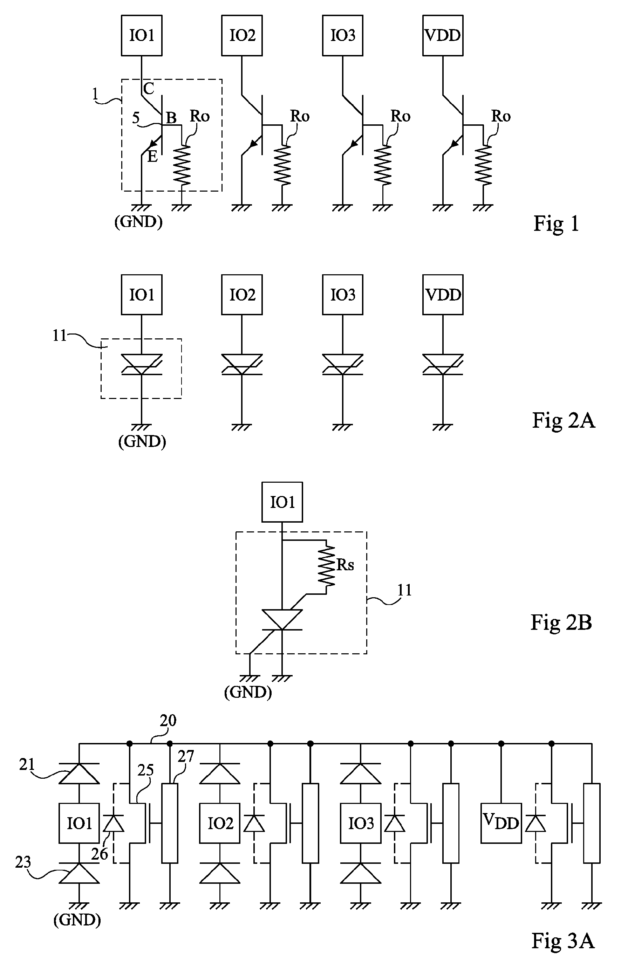

Sur les figures 1, 2A, et 3A, on a représenté trois plots d'entrée-sortie 101 à 103 et un plot d'alimentation haute V_{DD} d'un circuit intégré. Chaque plot est couplé à une structure de protection reliant le plot à une borne de masse (GND) du circuit. Le terme masse désigne ici et dans la suite de la description un potentiel de référence commun à divers composants du circuit intégré, par exemple un potentiel d'alimentation basse. Les connexions à la masse peuvent se faire par l'intermédiaire d'un rail de masse, ou rail d'alimentation basse, ce rail étant relié à un plot, accessible à l'extérieur du circuit et adapté à être mis au potentiel de référence choisi.

En figure 1, chaque plot est couplé à une structure de protection 1 comprenant un transistor bipolaire 5 de type NPN dont le collecteur C et l'émetteur E sont respectivement reliés au plot et à la masse, et dont la base B est reliée à la masse par l'intermédiaire d'une résistance R₀.

Pour permettre l'évacuation du courant entre deux plots du circuit, chaque structure de protection 1 associée à un plot doit pouvoir évacuer des surtensions entre le plot et la masse quelle que soit la polarité (positive ou négative) de la surtension.

En cas de surtension négative entre un plot et la masse, la jonction PN base-collecteur du transistor 5 associé au plot concerné, polarisée en direct, devient passante, et la surtension est évacuée.

En cas de surtension positive entre le plot et la masse, la jonction base-collecteur du transistor 5, polarisée en inverse, devient conductrice par effet d'avalanche, et le courant s'écoule vers la masse, en passant par la résistance R₀. Dès que la tension aux bornes de la résistance R₀ atteint un certain seuil, la jonction PN base-émetteur, polarisée en direct, devient passante, et la surtension est évacuée.

Un inconvénient des structures de protection à transistors bipolaires est que, dans le cas d'une surtension positive entre un plot et la masse, elles présentent une tension de déclenchement mal contrôlée (tension de retournement de la jonction base-collecteur). Il existe donc un risque que des composants du circuit intégré soient détruits avant que la protection n'intervienne. En outre, afin de supporter l'énergie dissipée lors d'une décharge électrostatique, les transistors bipolaires de protection 5 doivent avoir des dimensions importantes, ce qui pose des problèmes de surface de silicium et de capacités parasites.
La figure 2A représente une structure de protection à diodes de Shockley. Chaque plot est couplé à une diode de Shockley 11 connectée en direct entre le plot et la masse.
La figure 2B représente un schéma électrique équivalent d'une diode de Shockley, ou thyristor sans borne de gâchette. Dans ce thyristor, la région de gâchette de cathode est reliée à la cathode. Pour permettre la conduction en inverse de la structure, une résistance Rs est prévue entre la région de gâchette d'anode et l'anode du thyristor.

En cas de surtension négative entre un plot et la masse, la jonction PN entre la région de gâchette de cathode et la région de gâchette d'anode, polarisée en direct, devient passante, et la surtension est évacuée à travers la résistance Rs.

En cas de surtension positive entre le plot et la masse, le thyristor devient conducteur par retournement de la jonction PN formée entre ses régions de gâchette de cathode et de gâchette d'anode, et la surtension est évacuée.

Un avantage des structures de protection à thyristor est qu'elles présentent des performances d'évacuation de surtension nettement supérieures à celles des structures à transistor bipolaire. Ceci est notamment lié à la très faible tension subsistant aux bornes du thyristor, lorsque ce dernier est rendu passant en direct. A possibilités d'évacuation de surtensions équivalentes, les dimensions de la structure de protection 11 à thyristor des figures 2A et 2B sont très inférieures aux dimensions de la structure de protection 1 à transistor bipolaire de la figure 1. Il en résulte que les structures de protection à thyristor génèrent des capacités parasites nettement moindres que les structures de protection à transistor bipolaire.

Toutefois, comme pour les structures de protection à transistor bipolaire, un inconvénient des structures de protection à thyristor du type décrit en relation avec les figures 2A et 2B est qu'elles présentent une tension de déclenchement mal contrôlée (tension de retournement de la diode de Shockley). De plus, comme les zones semiconductrices constitutives de la diode sont formées de régions dopées prévues pour l'optimisation des composants actifs du circuit intégré, on peut difficilement obtenir des tensions de retournement optimales et on est amené à avoir des tensions de retournement trop élevées. Ainsi, il existe un risque que des composants du circuit intégré soient détruits avant que le déclenchement de la protection n'intervienne.

La figure 3A représente un autre exemple d'une structure de protection contre des décharges électrostatiques. Dans cette structure, des diodes 21 sont connectées en direct entre chaque plot d'entrée-sortie (I01, 102, I03) et un rail 20 d'alimentation haute relié au plot V_{DD}. Des diodes 23 sont connectées en inverse entre chaque plot d'entrée-sortie et la masse (GND). Au voisinage de chaque plot, un transistor MOS 25, utilisé comme interrupteur, est connecté entre le rail 20 d'alimentation haute et la masse. A chaque transistor 25 est associé un circuit de détection de surtension 27, connecté parallèlement au transistor 25, et adapté à fournir un signal de déclenchement à ce transistor. Chaque transistor MOS 25 comporte une diode parasite 26 connectée en direct entre la masse et le rail 20 d'alimentation haute.

En fonctionnement normal, lorsque la puce est alimentée, le potentiel de masse et les signaux sur les plots d'entrée-sortie et sur le rail 20 d'alimentation haute sont tels que les diodes 21 et 23 ne laissent pas passer de courant. En outre, les circuits de détection 27 rendent les transistors MOS 25 non passants.

En cas de surtension positive entre le plot V_{DD} et la masse, les circuits 27 rendent les transistors 25 passants, ce qui permet l'évacuation de la surtension.

En cas de surtension négative entre le plot V_{DD} et la masse, les diodes parasites 26 des transistors 25 deviennent passantes et la surtension est évacuée à travers ces diodes.

En cas de surtension positive entre un plot d'entrée-sortie et le plot V_{DD}, la diode 21 associée au plot d'entrée-sortie concerné devient passante, ce qui permet l'évacuation de la surtension.

En cas de surtension négative entre un plot d'entrée-sortie et le plot V_{DD}, les circuits 27 rendent les transistors 25 passants, et la surtension est évacuée par les transistors 25 et par la diode 23 associée au plot d'entrée-sortie concerné.

En cas de surtension positive entre un plot d'entrée-sortie et la masse, la diode 21 associée au plot concerné devient passante et la surtension positive est reportée sur le rail 20 d'alimentation haute, ce qui correspond au cas traité ci-dessus d'une surtension positive entre le plot V_{DD} et la masse.

En cas de surtension négative entre un plot d'entrée-sortie et la masse, la diode 23 associée au plot concerné devient passante, ce qui permet l'évacuation de la surtension.

En cas de surtension positive ou négative entre deux plots d'entrée-sortie, les diodes 21 ou 23 associées aux plots concernés deviennent passantes, et la surtension est reportée entre le rail 20 d'alimentation haute et la masse, ce qui correspond à l'un des cas de surtension traités ci-dessus.

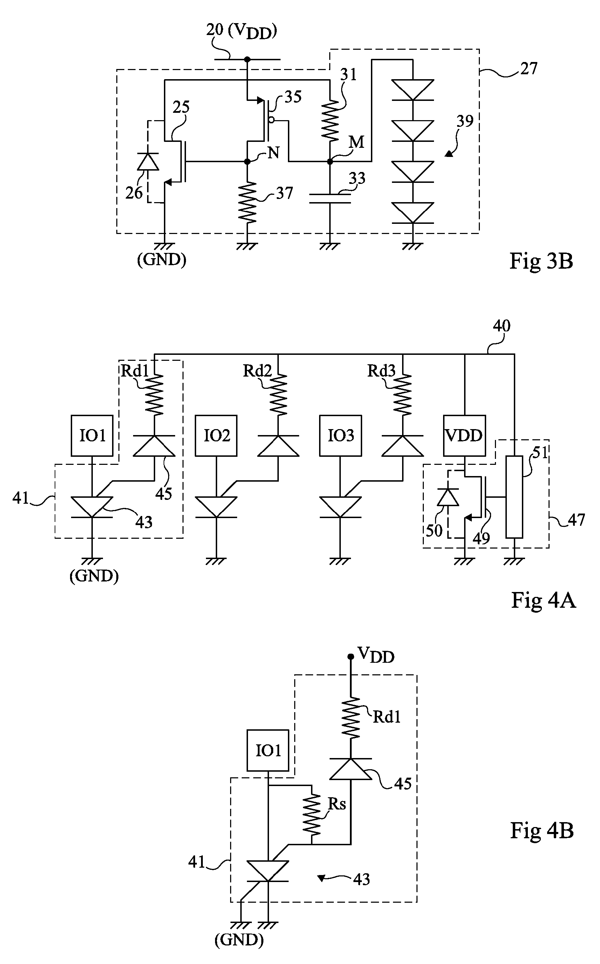

La figure 3B représente de façon plus détaillée un exemple de réalisation possible d'un circuit 27 de détection de surtension positive entre le rail 20 d'alimentation haute et la masse (GND), et de commande d'un transistor MOS de protection 25. Un détecteur de fronts, constitué d'une résistance 31 en série avec une capacité 33, est connecté entre le rail 20 d'alimentation haute et la masse. Le noeud M entre la résistance 31 et la capacité 33 est connecté à la grille d'un transistor MOS à canal P 35 dont la source est connectée au rail 20 d'alimentation haute et dont le drain est relié à la masse par l'intermédiaire d'une résistance 37. Le noeud N entre le drain du transistor 35 et la résistance 37 est connecté à la grille du transistor de protection 25. Un ensemble 39 de diodes en série est connecté en direct entre le noeud M et la masse. Dans cet exemple, l'ensemble 39 comprend quatre diodes en série.

En fonctionnement normal, lorsque le circuit est alimenté, le noeud M est à un état haut. Le transistor MOS à canal P 35 est donc ouvert. Ainsi, le noeud N de grille du transistor 25 est à un état bas, maintenant ce transistor ouvert. Lorsque la différence de potentiel entre le rail 20 d'alimentation haute et la masse augmente, le potentiel du noeud M augmente également. Lorsque le potentiel du noeud M atteint un certain seuil, l'ensemble de diodes 39 devient passant. Dans cet exemple, si chaque diode a une tension de seuil de 0,6 V, l'ensemble 39 devient passant lorsque le potentiel du noeud M dépasse 2,4 V. Le potentiel du noeud M cesse donc d'augmenter, alors que le potentiel du rail 20 d'alimentation haute continue à augmenter, ce qui provoque la fermeture du transistor MOS à canal P 35. Ainsi, le noeud N de grille du transistor de protection 25 passe à un état haut, c'est-à-dire sensiblement au même potentiel positif que le plot V_{DD}. Le transistor 25 devient donc passant, et la surtension est évacuée.

Lorsque le circuit intégré n'est pas alimenté, le noeud M est à un état bas. Le transistor 35 n'étant pas alimenté, le noeud N de drain de ce transistor est à un état indéterminé. Si une surtension positive brutale (montée de potentiel rapide) survient entre le plot V_{DD} et la masse, le noeud M reste à un état bas. Le transistor 35 devient donc passant et le noeud N passe à un état haut. Ainsi, le transistor de protection 25 est rendu passant, et la surtension est évacuée.

Un inconvénient de la structure de protection des figures 3A et 3B réside dans le fait que, pour pouvoir évacuer les courants induits par des décharges électrostatiques, les diodes 21 et 23 et les transistors 25 doivent avoir une surface importante (par exemple, un périmètre de jonction de 200 **µ**m par diode 21, 23 et une largeur de canal souvent supérieure à 1000 **µ**m par transistor 25, par exemple de l'ordre de 1000 à 10000 **µ**m). Il en résulte qu'une surface importante de silicium est exclusivement dédiée à la protection contre les décharges électrostatiques, au détriment des autres composants du circuit. En outre, du fait de leurs dimensions importantes, les transistors MOS 25 présentent des capacités parasites élevées, et sont traversés, à l'état bloqué, par des courants de fuite significatifs.

D'autres structures de protection comprenant une diode associée à un thyristor ont été décrites dans la demande de brevet internationale W02006/033993 et dans la demande de brevet américain US2002/0089017.

### Résumé

Ainsi, la présente invention vise à prévoir une structure de protection d'un circuit intégré contre des décharges électrostatiques palliant au moins en partie certains des inconvénients des solutions de l'art antérieur.

Ainsi, un mode de réalisation de la présente invention prévoit un circuit intégré protégé contre des décharges électrostatiques, ce circuit intégré comprenant des plots d'entrée-sortie et des premier et second rails d'alimentation, et : un thyristor connecté en direct entre chaque plot d'entrée-sortie et le second rail, chaque thyristor comportant, entre sa gâchette d'anode et son anode, une résistance ; entre chaque thyristor et le premier rail, une diode dont l'anode est reliée à la gâchette d'anode du thyristor et dont la cathode est reliée au premier rail par l'intermédiaire d'une résistance d'ajustement du déclenchement ; et un dispositif de déclenchement adapté à laisser circuler un courant entre les premier et second rails lorsqu'une surtension positive survient entre ces rails.

Selon un mode de réalisation de la présente invention, le dispositif de déclenchement comprend un transistor MOS à canal N dont le drain est connecté au premier rail et dont la source est connectée au second rail, et un circuit de détection de surtension adapté à fournir un signal de déclenchement à ce transistor.

Selon un mode de réalisation de la présente invention, le circuit de détection de surtension comprend : un détecteur de fronts constitué d'une résistance en série avec une capacité, connecté entre les premier et second rails d'alimentation ; un transistor MOS à canal P dont la source est connectée au premier rail et dont le drain est connecté au second rail par l'intermédiaire d'une résistance, la grille de ce transistor étant reliée au noeud entre la résistance et la capacité du détecteur de fronts, et la grille du transistor MOS à canal N étant connectée au drain du transistor MOS à canal P ; et un ensemble de diodes en série connecté en direct entre la grille du transistor MOS à canal P et le second rail d'alimentation.

Selon un mode de réalisation de la présente invention, le dispositif de déclenchement comprend une diode zener connectée en inverse entre les premier et second rails d'alimentation.

Selon un mode de réalisation de la présente invention, le dispositif de déclenchement comprend un transistor bipolaire de type NPN connecté entre les premier et second rails d'alimentation.

Selon un mode de réalisation de la présente invention, le dispositif de déclenchement est également un dispositif de protection adapté à évacuer des courants de surtension entre les premier et second rails d'alimentation.

Selon un mode de réalisation de la présente invention, des résistances d'ajustement du déclenchement associées à des plots d'entrée-sortie distincts, ont des valeurs distinctes.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, décrite précédemment, représente le schéma électrique d'une protection à base de transistors bipolaires ;
la figure 2A, décrite précédemment, représente le schéma électrique d'une protection à base de diodes de Shockley ;
la figure 2B, décrite précédemment, est un schéma électrique équivalent plus détaillé de la structure de protection de la figure 2A ;
la figure 3A, décrite précédemment, représente un autre exemple d'une structure de protection ;
la figure 3B, décrite précédemment, est un schéma électrique plus détaillée d'un élément de la structure de protection de la figure 3A ;
la figure 4A représente un exemple d'une structure de protection associée à des plots d'un circuit intégré selon un mode de réalisation de la présente invention ; et
la figure 4B est un schéma électrique équivalent plus détaillé d'un élément de la structure de protection de la figure 4A.

### Description détaillée

La figure 4A représente trois plots d'entrée-sortie I01 à I03 et un plot d'alimentation haute V_{DD}. Chaque plot d'entrée-sortie est couplé à une structure de protection 41 connectée entre ce plot, une borne de masse (GND) du circuit, et un rail 40 d'alimentation haute, relié au plot d'alimentation haute V_{DD}. Chaque structure de protection 41 comprend un thyristor 43, connecté en direct entre le plot d'entrée-sortie et la masse. La gâchette d'anode du thyristor 43 est reliée à l'anode d'une diode 45 dont la cathode est reliée au rail 40 par l'intermédiaire d'une résistance Rd1. On pourra prévoir, pour des structures de protection 41 associées à des plots d'entrée-sortie I01, 102, I03 distincts, des résistances Rd1, Rd2, Rd3 distinctes.

Par ailleurs, un bloc 47 est connecté entre le rail 40 (ou le plot V_{DD}) et la masse. Dans cet exemple, le bloc 47 comprend un transistor MOS 49, utilisé comme interrupteur, connecté entre le rail 40 (ou le plot V_{DD}) et la masse. Le bloc 47 comprend en outre un circuit 51 de détection de surtension, connecté parallèlement au transistor 49, et adapté à fournir un signal de déclenchement à ce transistor. Le circuit 51 pourra être sensiblement identique au circuit 27 décrit en relation avec la figure 3B. Le transistor MOS 49 comporte une diode parasite 50 connectée en inverse entre le rail 40 et la masse.

La figure 4B est un schéma électrique équivalent d'une structure de protection 41 de la figure 4A. La région de gâchette de cathode du thyristor 43 est reliée à la cathode de ce thyristor. Une résistance Rs relie la région de gâchette d'anode à l'anode du thyristor.

On décrira ci-dessous le fonctionnement de la structure de protection en relation avec les figures 4A et 4B.

En fonctionnement normal, lorsque la puce est alimentée, le potentiel de masse (GND) et les signaux sur les plots d'entrée-sortie et sur le rail 40 d'alimentation haute sont tels que les structures 41 ne laissent passer aucun courant. En outre, le circuit de détection 51 rend le transistor MOS 49 non passant.

En cas de surtension positive entre le plot V_{DD} et la masse, le circuit 51 rend le transistor 49 passant, ce qui permet l'évacuation de la surtension.

En cas de surtension négative entre le plot V_{DD} et la masse, la diode parasite 50 du transistor 49 devient passante, ce qui permet l'évacuation de la surtension.

En cas de surtension positive entre un plot d'entrée-sortie I01 et la masse, le thyristor 43, connecté en direct entre le plot I01 et la masse, est susceptible d'être rendu passant. Un potentiel positif est reporté sur le rail 40, à travers la résistance Rs associée au plot I01, la diode 45 associée au plot I01, et la résistance Rd1. Le circuit 51 rend donc le transistor MOS 49 passant, et il circule un courant entre le plot I01 et la masse, passant par la résistance Rs, la diode 45, la résistance Rd1, et le transistor 49. Lorsque la tension aux bornes de la résistance Rs atteint un certain seuil, la jonction PN formée entre l'anode et la gâchette d'anode du thyristor 43 devient passante. La tension de seuil de cette jonction est par exemple de l'ordre de 0,6 V. Il circule donc un courant de gâchette qui provoque la fermeture du thyristor 43, ce qui permet l'évacuation de la surtension.

En cas de surtension négative entre le plot d'entrée-sortie I01 et la masse, la jonction PN formée entre la région de gâchette de cathode et la région de gâchette d'anode du thyristor 43 associé au plot I01 devient passante, et la surtension est évacuée (à travers la résistance Rs).

En cas de surtension positive entre le plot d'entrée-sortie I01 et le plot V_{DD}, il existe une différence de potentiel positive entre le plot I01 et la masse, et le thyristor 43, connecté en direct entre le plot I01 et la masse, est susceptible d'être rendu passant. Il circule un courant entre le plot I01 et le plot V_{DD}, passant par la résistance Rs associée au plot I01, la diode 45 associée au plot I01, et la résistance Rd1. Lorsque la tension aux bornes de la résistance Rs atteint un certain seuil, la jonction PN formée entre l'anode et la gâchette d'anode du thyristor 43 devient passante. Il circule donc un courant de gâchette qui provoque la fermeture du thyristor 43, ce qui permet l'évacuation de la surtension à travers ce thyristor et à travers la diode 50.

En cas de surtension négative entre le plot d'entrée-sortie I01 et le plot V_{DD}, il existe une différence de potentiel positive entre le plot V_{DD} et la masse. Le circuit 51 rend donc le transistor MOS 49 passant, et la surtension positive est reportée sur la masse, ce qui correspond au cas traité ci-dessus d'une surtension négative entre le plot I01 et la masse. La surtension est donc évacuée à travers le transistor MOS 49 et la jonction PN formée entre la région de gâchette de cathode et la région de gâchette d'anode du thyristor 43 associé au plot I01 (à travers la résistance Rs associée au plot I01).

Pour décrire le fonctionnement de la protection en cas de surtension positive ou négative entre deux plots d'entrée-sortie du circuit, on considère le cas d'une surtension positive entre le plot I01 et le plot 102. Il existe une différence de potentiel positive entre le plot I01 et la masse. Le thyristor 43 connecté en direct entre le plot I01 et la masse est donc susceptible d'être rendu passant. Un potentiel positif est reporté sur le rail 40, à travers la résistance Rs associée au plot I01, la diode 45 associée au plot I01, et la résistance Rd1. Le circuit 51 rend donc le transistor MOS 49 passant, et il circule un courant entre le plot I01 et le plot 102, passant par la résistance Rs associée au plot I01, la diode 45 associée au plot I01, la résistance Rd1, le transistor 49, et par la jonction PN formée entre la région de gâchette de cathode et la région de gâchette d'anode du thyristor 43 associé au plot I02 (à travers la résistance Rs associée au plot I02). Lorsque la tension aux bornes de la résistance Rs associée au plot I01 atteint un certain seuil, la jonction PN formée entre l'anode et la gâchette d'anode du thyristor 43 associé au plot I01 devient passante. Il circule donc un courant de gâchette qui provoque la fermeture de ce thyristor. Ainsi, la surtension est évacuée à travers le thyristor 43 associé au plot I01 et à travers la jonction PN formée entre la région de gâchette de cathode et la région de gâchette d'anode du thyristor 43 associé au plot I02 (à travers la résistance Rs associée au plot I02).

On notera qu'en pratique, les thyristors sont souvent réalisés en association avec une diode substrat (non représentée), connectée en direct entre la cathode et l'anode du thyristor. Cette diode (en antiparallèle du thyristor) offre un chemin aux courants positifs masse-plot.

Ainsi, la structure de protection proposée permet d'évacuer tout type de surtension susceptible de survenir entre deux plots d'un circuit intégré.

On notera que dans certains circuits, il n'est pas nécessaire de prévoir un chemin d'évacuation des surtensions entre le rail d'alimentation haute et la masse. C'est par exemple le cas de certains circuits de type RF, dans lesquels le rail d'alimentation haute n'est pas relié à un plot accessible à l'extérieur du circuit. Dans ce cas, les dimensions du transistor MOS 49 peuvent être considérablement réduites. En effet, dans un tel circuit, quand une surtension survient sur un plot d'entrée-sortie, seule une faible partie de la surtension transite par le transistor MOS 49, pour permettre le passage d'un courant de déclenchement du thyristor 43 associé au plot concerné.

Selon une variante de réalisation de la structure proposée, on pourra prévoir, un élément de déclenchement ou de déclenchement et de protection entre le plot V_{DD} et la masse, autre que le bloc 47 à transistor MOS de la figure 4A. L'élément de déclenchement ou de déclenchement et de protection pourra par exemple être une diode zener, connectée en inverse entre le plot V_{DD} et la masse, et adaptée à conduire en direct, en cas de surtension négative entre V_{DD} et la masse, et en inverse, par effet d'avalanche, en cas de surtension positive entre V_{DD} et la masse. L'élément de déclenchement ou de déclenchement et de protection entre V_{DD} et la masse pourra également être un transistor bipolaire de type NPN.

Un avantage de la structure de protection proposée par rapport aux structures de protection à thyristor non contrôlé (diode de Shockley), du type décrit en relation avec les figures 2A et 2B, est qu'elle permet de choisir le niveau de tension auquel on souhaite que la protection se déclenche. Ce niveau de tension est notamment déterminé, d'une part par la sensibilité du circuit de détection de surtension 51, et d'autre part par la valeur des résistances Rs, Rd1, Rd2, Rd3, associées aux plots d'entrée-sortie. Plus les valeurs des résistances Rd1, Rd2, Rd3 sont élevées par rapport à Rs, plus le seuil de déclenchement de la protection est élevé (car le seuil de conductivité de la jonction formée entre l'anode et la gâchette d'anode du thyristor est atteint plus tardivement). La résistance Rs peut être de l'ordre de quelques dizaines à quelques centaines d'ohms, par exemple comprise entre 10 et 150 ohms, et les résistances Rd peuvent être de l'ordre de quelques centaines d'ohms ou plus, par exemple comprises entre 200 et 800 ohms. On notera que les résistances Rd sont nettement supérieures aux résistances parasites intrinsèques, de l'ordre de quelques ohms à quelques dizaines d'ohms, généralement présentes dans les chemins d'évacuation des structures de protection.

Pour un plot d'entrée-sortie IOi donné, la tension de déclenchement du thyristor est VIOᵢ = V_{DD} + Vₜₕ * (1 + Rdᵢ/Rs), où Vₜₕ est la tension de seuil de la jonction PN formée entre l'anode et la gâchette d'anode du thyristor. Le courant de déclenchement du thyristor est I = (VIOᵢ - V_{DD}) / (R + Rs), avec Rs * I = Vₜₕ.

Si l'élément de déclenchement prévu entre V_{DD} et la masse est une diode zener, un transistor bipolaire de type NPN, ou tout autre élément adapté, le niveau de tension de déclenchement de la protection sera lié à la sensibilité de cet élément.

On soulignera en particulier que la structure proposée permet de choisir, pour des plots d'entrée-sortie distincts, des seuils de déclenchement distincts, en prévoyant des valeurs distinctes pour les résistances Rd1, Rd2, Rd3. Une résistance plus élevée induira un seuil de déclenchement plus élevé, et réciproquement.

Un autre avantage de la structure de protection proposée est qu'elle occupe une surface de silicium nettement inférieure à la surface occupée par les structures de protection à transistor bipolaire du type décrit en relation avec la figure 1 et par les structures de protection à transistor MOS et à diodes du type décrit en relation avec les figures 2B et 2A. En effet, à possibilités d'évacuation de courant identiques, les thyristors 43 de la structure proposée ont des dimensions très inférieures à celles des transistors bipolaires de la figure 1. En outre, alors que la structure décrite en relation avec les figures 3A et 3B prévoit un grand nombre de transistors MOS de protection entre le rail d'alimentation haute et la masse, la structure proposée n'en prévoit qu'un seul.

Du fait de ses dimensions réduites, la structure proposée présente de faibles capacités parasites et de faibles courants de fuite, en fonctionnement normal, par rapport aux structures de protection existantes à transistors bipolaires ou à transistors MOS et à diodes.

## Revendications

1. Circuit intégré protégé contre des décharges électrostatiques, ce circuit intégré comprenant des plots d'entrée-sortie (I01, 102, I03) et des premier (40, V_{DD}) et second (GND) rails d'alimentation, et :
un thyristor (43) connecté en direct entre chaque plot d'entrée-sortie et le second rail, chaque thyristor comportant, entre sa gâchette d'anode et son anode, une résistance (Rs) ;
entre chaque thyristor et le premier rail, une diode (45) dont l'anode est connectée à la gâchette d'anode du thyristor et dont la cathode est reliée au premier rail par l'intermédiaire d'une résistance (Rd1, Rd2, Rd3) d'ajustement du déclenchement ; et
un dispositif de déclenchement (47) adapté à laisser circuler un courant entre les premier et second rails lorsqu'une surtension positive survient entre ces rails.

2. Circuit intégré selon la revendication 1, dans lequel le dispositif de déclenchement (47) comprend un transistor MOS à canal N (49) dont le drain est connecté au premier rail (40, V_{DD}) et dont la source est connectée au second rail (GND), et un circuit de détection de surtension (27 ; 51) adapté à fournir un signal de déclenchement à ce transistor.

3. Circuit intégré selon la revendication 2, dans lequel le circuit de détection (27 ; 51) de surtension comprend :
un détecteur de fronts constitué d'une résistance (31) en série avec une capacité (33), connecté entre les premier (40, V_{DD}) et second (GND) rails d'alimentation ;
un transistor MOS à canal P (35) dont la source est connectée au premier rail et dont le drain est connecté au second rail par l'intermédiaire d'une résistance (37), la grille de ce transistor étant reliée au noeud (M) entre la résistance (31) et la capacité (33) du détecteur de fronts, et la grille du transistor MOS à canal N (49) étant connectée au drain du transistor MOS à canal P (35) ; et
un ensemble (39) de diodes en série connecté en direct entre la grille du transistor MOS à canal P (35) et le second rail d'alimentation.

4. Circuit intégré selon la revendication 1, dans lequel le dispositif de déclenchement comprend une diode zener connectée en inverse entre les premier (40, V_{DD}) et second (GND) rails d'alimentation.

5. Circuit intégré selon la revendication 1, dans lequel le dispositif de déclenchement comprend un transistor bipolaire de type NPN connecté entre les premier (40, V_{DD}) et second (GND) rails d'alimentation.

6. Circuit intégré selon l'une quelconque des revendications 1 à 5, dans lequel le dispositif de déclenchement (47) est également un dispositif de protection adapté à évacuer des courants de surtension entre les premier (40, V_{DD}) et second (GND) rails d'alimentation.

7. Circuit intégré selon la revendication 1 à 6, dans lequel des résistances d'ajustement du déclenchement (Rd1, Rd2, Rd3) associées à des plots d'entrée-sortie distincts, ont des valeurs distinctes.
